# EUROPEAN PATENT APPLICATION

(11) **EP 4 811 035 A1**
(43) Date of publication of application: **23.09.2026**
(21) Application number: 25165418.2
(22) Date of filing: 21.03.2025
(51) Int. Cl.: G03F 1/62, G03F 7/00

(54) **PELLICLE**

(71) Applicant: ASML Netherlands B.V., 5500 AH Veldhoven (NL)
(72) Inventor: FROTA SARTORI, André, 5500 AH Veldhoven (NL); SRIKANTA, Vedavathi, 5500 AH Veldhoven (NL); FERRE LLIN, Lourdes, 5500 AH Veldhoven (NL); DE GRAAF, Dennis, 5500 AH Veldhoven (NL); DE BRUIJN, Cornelis Cornelia, 5500 AH Veldhoven (NL)
(74) Representative: ASML Netherlands B.V.

(57) **Abstract**

A pellicle for an apparatus for semiconductor processes comprising: a pellicle film; a border forming at least part of a support layer for supporting the pellicle film; and a sacrificial layer; wherein the sacrificial layer is disposed between and directly contacts the pellicle film and the support layer. Also described is an apparatus for semiconductor processes comprising such a pellicle. In addition, there is provided method of manufacturing a pellicle for an exposure apparatus for semiconductor manufacturing processes, the method comprising: depositing an sacrificial layer on a front side of a silicon support layer; applying a mask to define border regions at a back side of the silicon support layer; and depositing a metal silicide layer directly onto the sacrificial layer.

## Description

### FIELD

The present invention relates to a pellicle for an apparatus for semiconductor processes. In particular, apparatus for semiconductor processes may be an extreme ultraviolet (EUV) exposure apparatus. The present disclosure also relates to an apparatus for semiconductor processes comprising such a pellicle. Also described is a method of manufacturing a pellicle as well as the use of such a pellicle and apparatus for semiconductor processes. The present disclosure has particular, but not exclusive application, to EUV exposure apparatus such as EUV utilization apparatus, for example EUV lithography apparatus or inspection tools.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A patterning device (e.g., a mask or reticle) is used to impart a pattern to a radiation beam in a lithographic apparatus. The patterning device may be protected by a pellicle from particle contamination. The pellicle may be supported by a pellicle frame.

A typical pellicle comprises a film which is located away from the patterning device and is out of the focal plane of a lithographic apparatus in use. Since the film is offset from the focal plane of the lithographic apparatus, contamination particles which land on the pellicle are held out of the focal plane of lithographic apparatus. Consequently, (focused) images of contamination particles are not projected onto the substrate. If the pellicle were not present, contaminating particles landing on the patterning device would be projected onto the substrate, introducing a defect into the projected pattern.

In a lithographic apparatus such as this, it is desirable that the EUV radiation is readily transmitted to the substrate for effective and efficient formation of features on the substrate. However, radiation outside the desired, EUV, wavelength range may also be projected towards the substrate from the projection system of the lithographic apparatus. Certain wavelengths of radiation may be undesired, for example due to their potential to cause harm to the substrate or interfere with the formation of features on the substrate by the EUV radiation. For this reason, it can be desirable to provide a spectral filter within the lithographic apparatus to suppress transmission of undesired wavelengths of radiation towards the substrate, while allowing transmission of the desired, EUV, wavelengths of radiation. Herein, by pellicle it is also understood a spectral filter.

A typical pellicle also comprises a border for supporting the pellicle film with sacrificial layers disposed between the pellicle film and the border.

The pellicle may comprise a core layer. The pellicle may comprise one or more capping layers arranged adjacent to the core layer or on top of each other. The pellicle may comprise a border supporting the pellicle film.

In some embodiments, the above-described pellicle films may further comprise one or more capping layers, Capping layers may provide additional thermo-chemical stability to a pellicle film. The additional layers may be provided to improve the thermal or optical behaviour of the overall composite membrane. The additional membrane layers may beneficially comprise a material with a high EUV transmission.

A mask assembly may include the pellicle which protects a patterning device (e.g. a mask) from particle contamination. The pellicle may be supported by a pellicle frame, forming a pellicle assembly. The pellicle may be attached to the frame, for example, by gluing or otherwise attaching a pellicle border region to the frame. The frame may be permanently or releasably attached to a patterning device.

It is beneficial for a pellicle membrane to be highly transmissive, for example having a single-pass EUV transmission (EUVT) of 90% or higher. It is also beneficial for a pellicle to be highly thermally emissive, for example having an emissivity close to or equal to 1 in the infrared range. It is beneficial for a pellicle membrane to have a high emissivity because a pellicle membrane with a higher emissivity can typically be used at a higher operating temperature without risking damage to or instability of the membrane, compared to a pellicle membrane with a lower emissivity. It is beneficial for a pellicle membrane to have mechanical stability so as to avoid damage to the pellicle during manufacture, storage, transportation and/or use. It is typically difficult to achieve optimal transmissivity, emissivity and mechanical stability due to competing requirements and physical limitations of suitable materials.

Known EUV pellicles may be fragile and have low reliability. Pellicle breakages can often occur during transport, handling, and operation. In operation in a lithographic apparatus or an actinic inspection tool, the pellicle may be subjected to mechanically-, electrically- and/or chemically - induced breakage.

The present invention has been devised in an attempt to address at least some of the problems identified above.

### SUMMARY

According to a first aspect there is provided a pellicle for an apparatus for semiconductor processes comprising: a pellicle film; a border forming at least part of a support layer for supporting the pellicle film; and a sacrificial layer; wherein the sacrificial layer is disposed between and directly contacts the pellicle film and the support layer.

In existing pellicles, the provision of multiple low-conductivity sacrificial layers results in a high electrical resistance across the layers of the pellicle and thus a low rate of electrical dissipation. This allows high levels of charge to accumulate across the pellicle under operating conditions. With sufficient charge accumulation, electrostatic discharge (ESD) occurs, resulting in damage or rupture of the pellicle.

Advantageously, by providing a sacrificial layer disposed between, and directly in contact with, the pellicle film and the support layer, the overall resistance across the pellicle can be reduced. This lowers the risk of ESD - induced pellicle rupture since charge is less able to accumulate to levels where electrostatic discharge may occur. This is because the charge can more readily leak away over time. As a result, thinner pellicle films can be used without undue risk of ESD-induced failure.

The pellicle film may be a metal silicide film.

The metal silicide film may be a molybdenum silicide film, optionally a doped molybdenum silicide film, optionally a molybdenum silicon nitride film.

The sacrificial layer may be a thermal oxide layer, optionally wherein the sacrificial layer comprises silicon oxide.

The sacrificial layer may be around 300nm or less in thickness, optionally wherein the sacrificial layer is around 250 nm or less, around 200 nm or less, around 150 nm or less, or around 100 nm or less in thickness.

The sacrificial layer may be thinner than the silicon border.

Existing pellicles have sacrificial layers greater than 300nm in thickness.

Advantageously, by providing a thinner sacrificial layer, the overall resistance across the pellicle is reduced. This lowers the risk of ESD-induced pellicle rupture.

The pellicle film may be around 50 nm or less, around 20 nm or less, or around 15 nm or less in thickness.

Advantageously, thinner pellicle films are more transmissive for radiation.

The pellicle film may include grains and the grains may have a longest dimension less than a thickness of the pellicle film.

Advantageously, this provides grain boundaries which impede crack propagation through the thickness of the film, strengthening the pellicle film.

According to a second aspect of the present disclosure, there is provided an apparatus for semiconductor processes comprising a pellicle according to the first aspect. The pellicle may comprise any of the optional features above.

The apparatus may be a lithographic apparatus, such as an EUV lithographic apparatus, a metrology apparatus, or an inspection apparatus, such as a mask inspection apparatus, such as an actinic mask inspection apparatus.

According to a third aspect there is provided a method of manufacturing a pellicle for an exposure apparatus for semiconductor manufacturing processes, the method comprising: depositing a sacrificial layer on a front side of a silicon support layer; applying a mask to define border regions at a back side of the silicon support layer; and depositing a metal silicide layer directly onto the sacrificial layer.

Advantageously, by depositing a single sacrificial layer between, and directly in contact with the pellicle film and the support layer, the overall resistance across the pellicle can be reduced. As mentioned above, this lowers the risk of ESD-induced pellicle rupture. As a result, thinner pellicle films can be used without undue risk of ESD-induced failure.

It should be noted that references to layer deposition in this specification should also be taken to encompass layer growth (e.g. as seen in thermal oxide layer formation).

The method may further comprise selectively etching the support layer and sacrificial layer to leave a freestanding metal silicide layer supported at an outer perimeter by a border defined by the remaining portion of the sacrificial layer and support layer.

The method may further comprise further depositing additional silicon-based and/or oxide sacrificial layers and subsequently etching the additional sacrificial layers.

By etching/stripping additional layers, the above-described methods of pellicle manufacturing achieves a significantly lower rate of defects, relative to previous methods. This is because each instance of layer deposition can introduce defects, and also etching processes act to clean surfaces, reducing defectivity of remaining layers.

The method may further comprise annealing the freestanding metal silicide layer at around 900° C or less, around 850° C or less, or around 800° C or less.

Advantageously annealing the freestanding metal silicide layer at lower temperatures (relative to existing methods) reduces the grain size and thus increases the strength of the metal silicide layer.

The method may further comprise annealing the freestanding metal silicide layer at around 700° C or greater. For example, the annealing may take place at a temperature of from around 700 to around 900° C. Below 700° C the metal silicide layer, such as a molybdenum silicon nitride layer, may not crystallise sufficiently to form the metal silicide. Between 700 and 900° C, the metal silicide layer crystallises sufficiently, with more homogenous crystals, such as smaller crystals, preferentially forming at the lower end of this range.

Annealing at the freestanding metal silicide layer at around 700° C or greater, results in a sufficiently homogeneous metal silicide layer.

Deposition of the metal silicide layer may take place in an atmosphere comprising around 5% or more, around 10% or more, around 15% or more, around 20% or more, around 25% or more, around 30% or more, or around 35% or more nitrogen gas (vol%).

Advantageously increasing the nitrogen content of the metal silicide layer (relative to known metal silicide layers) increases the resilience against etchants during manufacturing. This allows use of thinner, more transmissive metal silicide layers.

The metal silicide layer may be molybdenum silicon nitride.

The sacrificial layer may be a thermal oxide.

The step of depositing a sacrificial layer may include depositing a sacrificial layer having a thickness of around 300 nm or less.

Advantageously, by depositing a thinner sacrificial layer, the overall resistance across the pellicle is reduced.

Further advantageously, minimising the thickness of the sacrificial layer (e.g. 300nm or less), reduces the degree of over-etch necessary during manufacturing. The integrity and desired performance and function of the freestanding metal silicide layer is preserved as a result of the reduced over-etch.

According to a fourth aspect there is provided the use of a pellicle according to the first aspect, an apparatus according to the second aspect, or a method according to the third aspect in a method or apparatus for semiconductor processes. The pellicle, apparatus and/or method may comprise any of the optional features above.

According to a fifth aspect of the present disclosure, there is provided a pellicle assembly for a lithographic tool, such as a lithographic apparatus, comprising the pellicle of the first aspect and a pellicle frame for supporting the pellicle. Preferably the pellicle frame supports the pellicle at the periphery of the border. The device assembly may comprise such a pellicle assembly mounted on a patterning device for a lithographic apparatus.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically depicts a pellicle assembly in a cross-sectional view;
- Figure 3 schematically depicts a known pellicle;
- Figure 4 schematically depicts a pellicle according to an embodiment of the present invention;
- Figure 5 schematically depicts a method of manufacturing a pellicle according to an embodiment of the present invention; and
- Figures 6a-6c illustrate a sequence of stages in a method of manufacturing a pellicle according to another embodiment of the present invention.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

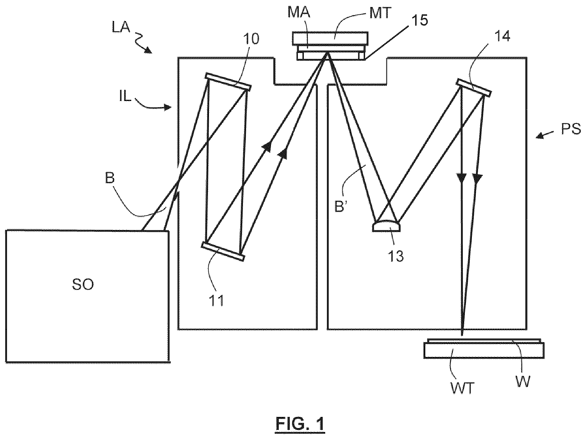

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11. The patterning device MA is protected by a pellicle assembly 15. In this embodiment, the pellicle 15 is depicted in the path of the radiation and protecting the patterning device MA. It will be appreciated that the pellicle 15 may be located in any required position and may be used to protect any of the mirrors in the lithographic apparatus. The pellicle 15 may be part of a spectral purity filter. In an embodiment the membrane assembly 15 comprises a membrane formed from the at least one membrane layer configured to transmit at least 90% of incident EUV radiation. In order to ensure maximized EUV transmission and minimized impact on imaging performance it is preferred that the membrane is only supported at the border.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

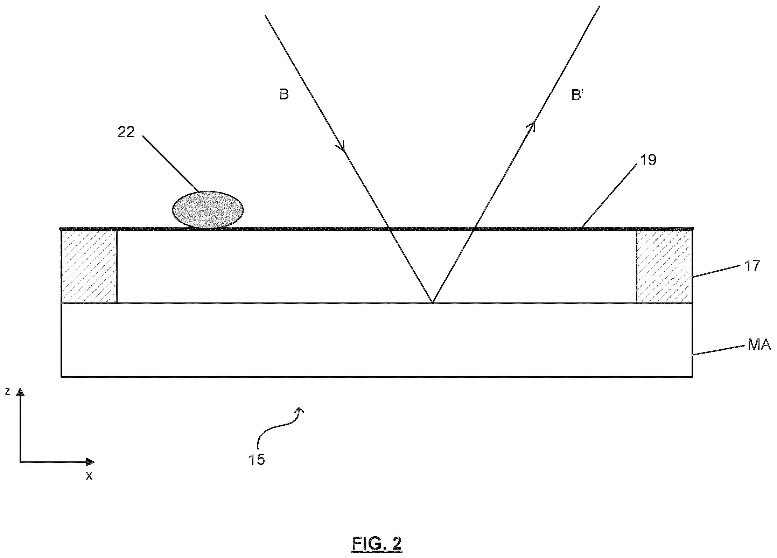

Figure 2 schematically illustrates the pellicle assembly 15 in situ on the patterning device MA. The pellicle assembly comprises a pellicle 19 according to an embodiment of the present disclosure that is held in place by a pellicle frame 17. The pellicle 19 may be attached to the frame 17 by gluing. Although not illustrated, frame 17 may comprise additional hardware for fixing the frame, and by extension the pellicle assembly, to the patterning device MA.

The pellicle 19 is provided in the path of both the incident radiation beam B and the reflected patterned radiation beam B'. The radiation beam passes through the pellicle 19 twice. The pellicle 19 is substantially transparent to EUV radiation (although it will absorb a small amount of EUV radiation). The pellicle 19 acts to protect the patterning device MA from particle contamination. Whilst efforts may be made to maintain a clean environment inside the lithographic apparatus LA, particles may still be present inside the lithographic apparatus LA. In the absence of the pellicle 19, particles may be deposited onto the patterning device MA. Particles on the patterning device MA in the focal plane of the lithographic apparatus may disadvantageously impact the pattern that is imparted to the radiation beam B and therefore the pattern that is transferred to the substrate W. The pellicle 19 provides a barrier between the patterning device MA and the environment in the lithographic apparatus LA in order to prevent particles from being deposited on the patterning device MA.

In use, the pellicle 19 of the pellicle assembly 15 is positioned at a distance from the patterning device MA by the pellicle frame 17. The distance is sufficient to separate particles (e.g. particle 22) incident upon the surface of the film from the focal plane of the radiation beam B. The distance between the pellicle 19 and the patterning device MA, acts to reduce the extent to which any particles on the surface of the pellicle 19 impart a pattern to the radiation beam B. A particle present in the beam of radiation B, but not at a focal plane of the beam of radiation B (i.e., not at the surface of the patterning device MA), will not be in focus at the surface of the substrate W. In the absence of other considerations, it may be desirable to position the film a considerable distance away from the patterning device MA. However, in practice the space which is available in the lithographic apparatus LA to accommodate the pellicle assembly 15 is limited due to the presence of other components.

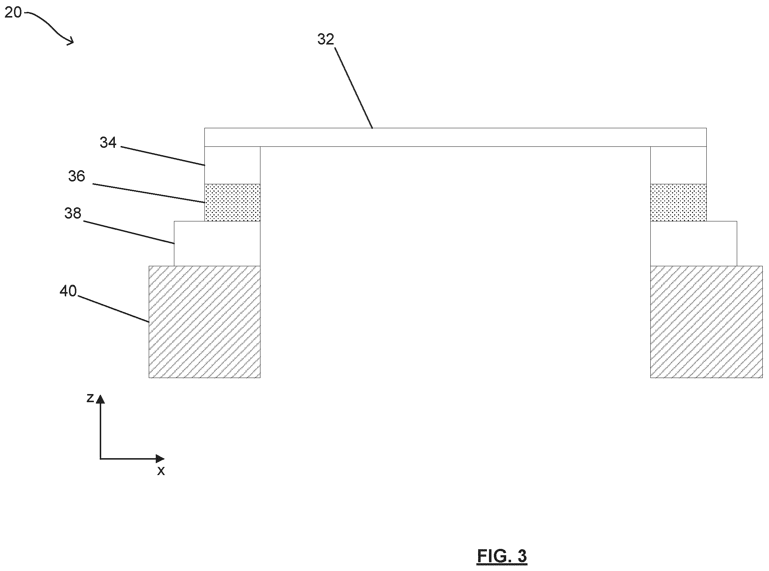

Figure 3 schematically illustrates a known pellicle 18. The pellicle 19 comprises a pellicle film 32. The pellicle 18 further comprises, starting from the pellicle film 32, a second sacrificial layer 34, a silicon-based sacrificial layer 36, a first sacrificial layer 38, and a support layer 40.

The central portions of the second sacrificial layer 34, silicon-based sacrificial layer 36, first sacrificial layer 38, and support layer 40 are selectively etched to leave a freestanding EUV-transmissive pellicle film supported at an outer perimeter by the remaining portions of the first and second sacrificial layer 38, 34, and the support layer 40 (collectively referred to as the border).

The pellicle film 32 may be a metal silicide film.

The first and second sacrificial layers 38, 34 typically comprise an oxide material with low conductivity, such as silicon oxide. The support layer 40 is silicon.

It has been realised that the provision of multiple low-conductivity layers in the supporting portion results in a relatively high electrical resistance across the layers of the pellicle and thus a low rate of charge dissipation. This allows high levels of charge to accumulate across the pellicle 19 under operating conditions within a lithographic apparatus or actinic inspection tool, or indeed any other system requiring a pellicle. With sufficient charge accumulation, electrostatic discharge (ESD) occurs, resulting in damage to or the rupture of the pellicle 18.

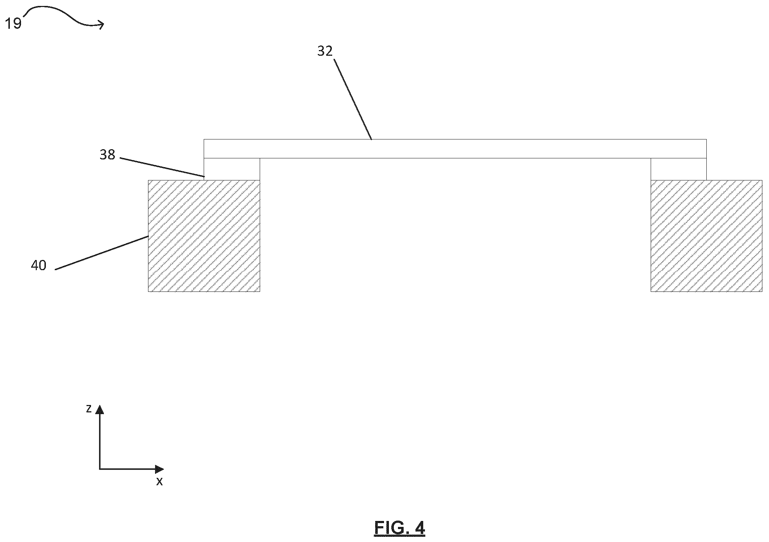

Figure 4 is schematic illustration of a pellicle 19, according to an embodiment of the present invention.

The pellicle comprises a pellicle film 32, a support layer 40 for supporting the pellicle film, and a (first) sacrificial layer 38. The sacrificial layer 38 is disposed between, and directly contacts the pellicle film 32 and the support layer 40. Put alternatively, the number of layers in the supporting portion has been reduced (relative to known pellicle 18).

The pellicle film 32 may be a metal silicide film. In particular, the molybdenum silicide film, may be a doped molybdenum silicide film, and optionally a molybdenum silicide nitride film.

The sacrificial layer 38 comprises a thermal oxide material, such as silicon oxide. The sacrificial layer may be around 300nm or less in thickness. The sacrificial layer 34 is thinner than the silicon support layer 40.

In other embodiments, the sacrificial layer may be around 250 nm or less, around 200 nm or less, around 150 nm or less, or around 100 nm or less in thickness.

A thinner supporting portion lowers the overall resistance across the pellicle, and therefore lowers the risk of ESD - induced pellicle rupture. As a result, thinner and more transmissive pellicle films can be used without undue risk of ESD-induced failure.

In some embodiments the pellicle film 32 is around 50 nm or less, around 20 nm or less, or around 15 nm or less in thickness.

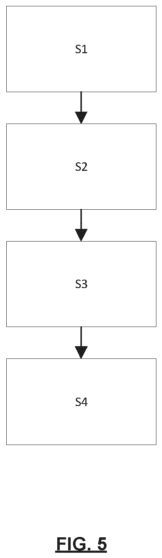

Figure 5 schematically illustrates a method of manufacturing a pellicle according to an embodiment of the invention.

At S1, a sacrificial layer (e.g. a thermal oxide layer) is formed on a front side of a silicon support layer. Preferably, the sacrificial layer is deposited as thinly as possible - e.g. 300nm or less.

At S2, a mask is applied to define border regions at a back side of the silicon support layer; and

At S3 a metal silicide (e.g. Molybdenum Silicon Nitride) layer is deposited directly onto the sacrificial layer.

Optionally, at S4 the support layer and sacrificial layer is selectively etched to leave a freestanding metal silicide layer supported at an outer perimeter by a border defined by the remaining portion of the sacrificial layer and support layer.

In practice, additional processes may be utilised. For example, the method may further comprise further depositing additional silicon-based and/or oxide sacrificial layers and subsequently etching the additional sacrificial layers.

In addition, the method may further comprise annealing the metal silicide layer at around 900° C or less, around 850° C or less, around 800° C or less, and/or 700° C or more. The effect of annealing will be discussed below.

PVD or CVD type processes may be used to deposit one or more of the above-described layers.

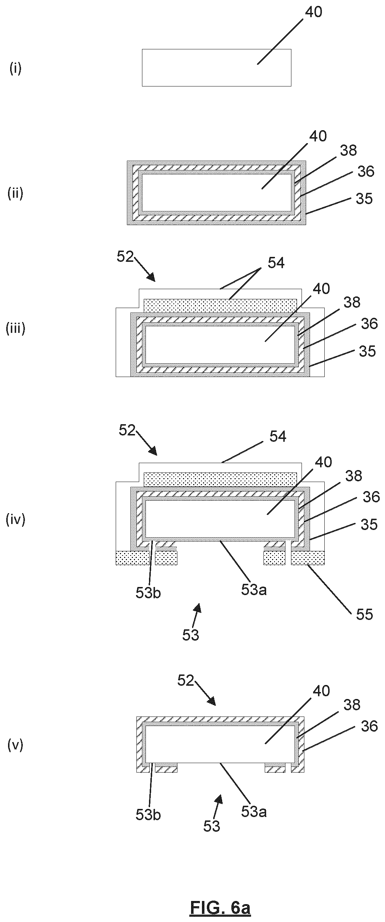

Figures 6a to 6c show a sequence of stages in a method of manufacturing a pellicle according to another embodiment of the invention.

Starting from Figure 6a, at (i), a silicon support layer 40 is provided. This may be in the form of a silicon wafer.

A first thermal oxide sacrificial layer 38, a silicon-based sacrificial layer 36, a second thermal oxide sacrificial layer 35 are successively deposited onto the silicon support layer 40 as shown at (ii). Preferably, first thermal oxide sacrificial layer 38 is deposited as thinly as possible - e.g. 300nm or less.

At (iii) front side protection 54 is deposited at a front side 52.

At (iv) A photoresist mask 55 defining the border is applied at a back side 53 and the assembly is etched to reveal the first thermal oxide sacrificial layer 38 at central portions 53a and peripheral portions 53b of the back side, as shown at (v).

At (v) the front side protection 54 and any exposed thermal oxide is stripped by etching. Note that the etching at (iv) also results in the selected portions 53a, 53b of first thermal oxide sacrificial layer 38 exposed at (iv) being stripped to reveal the underlying silicon support.

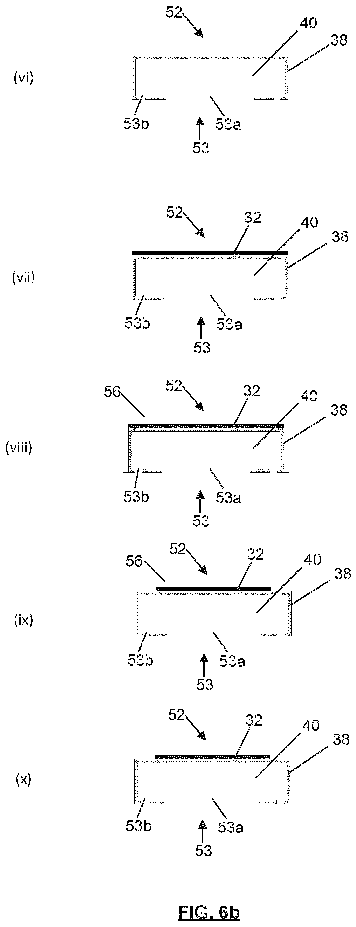

Turning to Figure 6b, at (vi) the silicon-based sacrificial layer 36 is stripped by an etchant to reveal the first thermal oxide sacrificial layer 38. In an example this etchant may be tetramethylammonium hydroxide (TMAH), which etches thermal oxide layers relatively slowly. In known pellicle manufacturing methods the silicon-based sacrificial layer 36 is not etched away and a further thermal oxide layer deposited on top (cf. known pellicle 18).

At (vii) a molybdenum silicon nitride layer 32 (MoSiN) is deposited at the front side 52. Preferably, deposition of the MoSiN layer 32 may take place in an atmosphere comprising around 15% or more nitrogen gas. A protective top cap 56 is also deposited on top of the MoSiN layer, as shown in (viii), and the assembly is annealed.

The annealing process is carried out at at around 900° C or less, around 850° C or less, around 800° C or less. This reduces the grain size and thus increases the strength of the metal silicide MoSiN layer. The annealing process is carried out at at around 700° C or more because annealing at lower temperatures may result in insufficient crystallization and therefore insufficient homogeneity of the MoSiN layer.

At (ix) peripheral portions of the top cap 56 and MoSiN layer 32 are selectively removed. The top cap 56 is removed, as shown at (x).

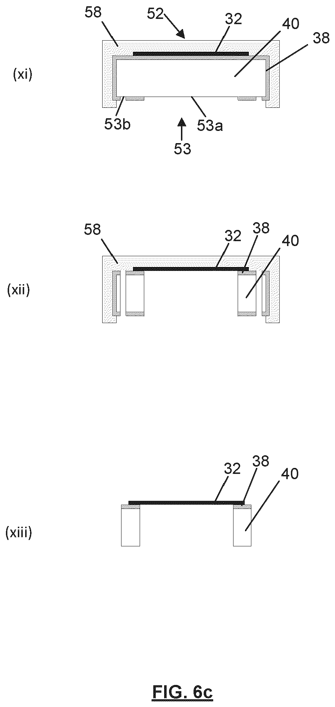

Turning to Figure 6c, at (xi) parylene 58, or another suitable protective layer, is applied to the front side 52 of the assembly to protect the MoSiN layer 32 from etchant. The parylene or other suitable protective layer also supports the pellicle once it is released from the wafer.

The assembly is then subjected to a TMAH and buffered oxide etch (BOE) which etches through the thickness of the silicon support 40 and first thermal oxide sacrificial layer 38 to leave a freestanding MoSiN layer (i.e. the pellicle film) 32 supported at an outer perimeter by a border defined by the remaining portion of the sacrificial thermal oxide layer 38 and the support layer 40 as shown at (xii).

In order to ensure complete removal of the first thermal oxide sacrificial layer 38 inside the border, the assembly is over-etched with BOE. Complete removal is necessary to ensure the pellicle transmits EUV radiation as required. On the other hand, over-etching weakens the MoSiN layer, rendering the pellicle more prone to failure.

The degree of BOE over-etch is proportional with the thickness of the first thermal oxide sacrificial layer 38. Advantageously, minimising the thickness of the first thermal oxide sacrificial layer 38 (e.g. 300nm or less), reduces the degree of BOE over-etch necessary. The freestanding MoSiN layer is stronger as a result of the reduced over-etch. Excessive over-etch needs to be prevented otherwise the strength of the molybdenum silicon nitride layer may be negatively affected. The etchant starts to attack the molybdenum silicon nitride to create defects, such as in the form of pinholes.

Depositing the MoSiN layer in an atmosphere comprising around 15% or more nitrogen gas, increases the nitrogen content of the MoSiN layer (relative to known MoSiN layers) and increases the resilience against BOE over-etch.

Removal of the parylene (e.g. with an appropriate solvent or in any oxygen plasma) leaves the pellicle 19 shown at (xiii) which can then be mounted onto a frame 17 (see Figure 2) for use.

By depositing fewer layers and etching/stripping more layers, the above-described methods of pellicle manufacturing achieves a significantly lower rate of defects, relative to previous methods. This is because each layer deposition can introduce defects, so minimising the number of deposited layers and/or etching them away reduces defectivity. As an additional remark, etching processes can act to clean surfaces, further reducing defects.

An additional, or alternative way of strengthening the pellicle film is to manufacture it such that it includes grains and the grains have a longest dimension less than a thickness of the pellicle film. This impedes crack propagation through the thickness of the film. As mentioned, this may be achieved by utilising an annealing temperature window of from around 700 to around 900° C.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools or apparatus for semiconductor processes. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A pellicle for an apparatus for semiconductor processes in a lithographic tool comprising:
a pellicle film;
a border forming at least part of a support layer for supporting the pellicle film; and
a sacrificial layer;
wherein the sacrificial layer is disposed between and directly contacts the pellicle film and the support layer.

2. The pellicle according to claim 1, wherein the pellicle film is a metal silicide film.

3. The pellicle according to claim 2, wherein the metal silicide film is a molybdenum silicide film, optionally a doped molybdenum silicide film, optionally a molybdenum silicon nitride film.

4. The pellicle according to any preceding claim, wherein the sacrificial layer is a thermal oxide layer, optionally wherein the sacrificial layer comprises silicon oxide.

5. The pellicle according to any preceding claim wherein the sacrificial layer is around 300nm or less in thickness, optionally wherein the sacrificial layer is around 250 nm or less, around 200 nm or less, around 150 nm or less, or around 100 nm or less in thickness.

6. The pellicle according to any preceding claim, wherein the sacrificial layer is thinner than the silicon border.

7. The pellicle according to any preceding claim, wherein the pellicle film is around 50 nm or less, around 20 nm or less, or around 15 nm or less in thickness.

8. The pellicle according to any preceding claim, wherein the pellicle film includes grains and the grains have a longest dimension less than a thickness of the pellicle film.

9. An apparatus for semiconductor processes comprising a pellicle according to any of claims 1 to 8.

10. The apparatus for semiconductor processes according to claim 9, wherein the apparatus is a lithographic apparatus, such as an EUV lithographic apparatus, a metrology apparatus, or an inspection apparatus, such as a mask inspection apparatus, such as an actinic mask inspection apparatus.

11. A method of manufacturing a pellicle for an exposure apparatus for semiconductor manufacturing processes, the method comprising:
depositing an sacrificial layer on a front side of a silicon support layer;
applying a mask to define border regions at a back side of the silicon support layer; and
depositing a metal silicide layer directly onto the sacrificial layer.

12. The method according to claim 11, wherein the method further comprises: selectively etching the support layer and sacrificial layer to leave a freestanding metal silicide layer supported at an outer perimeter by a border defined by the remaining portion of the sacrificial layer and support layer.

13. The method according to claim 11 or 12, wherein the method further comprises further depositing additional silicon-based and/or oxide sacrificial layers and subsequently etching the additional sacrificial layers.

14. The method of any of claims 11 to 13 wherein the method further comprises annealing the freestanding metal silicide layer at around 900° C or less, around 850° C or less, or around 800° C or less.

15. The method of any of claims 11 to 14, wherein the method further comprises annealing the freestanding metal silicide layer at around 700° C or greater.

16. The method of any of claims 11 to 15, wherein deposition of the metal silicide layer takes place in an atmosphere comprising around 5% or more, around 10% or more, around 15% or more, around 20% or more, around 25% or more, around 30% or more, or around 35% or more nitrogen gas (vol%).

17. The method of any of claims 11 to 16 wherein the metal silicide layer is molybdenum silicon nitride.

18. The method of any of claims 11 to 17 wherein the sacrificial layer is a thermal oxide.

19. The method of any of claims 11 to 18, wherein the step of depositing a sacrificial layer includes depositing a sacrificial layer having a thickness of around 300 nm or less.

20. The use of a pellicle according to any of claims 1 to 8, an apparatus according to claim 9 or claim 10, or method according to any of claims 11 to 19 in a method or apparatus for semiconductor processes.

21. A pellicle assembly for a lithographic tool, such as a lithographic apparatus, comprising the pellicle of claims 1 to 8 and a pellicle frame for supporting the pellicle (at periphery at the border).

22. A patterning device assembly comprising the pellicle assembly of claim 21 mounted on a patterning device for a lithographic apparatus.
